# EUROPEAN PATENT APPLICATION

(11) **EP 0 895 276 A1**
(43) Date of publication of application: **03.02.1999**
(21) Application number: 97830406.1
(22) Date of filing: 31.07.1997
(51) Int. Cl.: H01L 21/00, H01L 21/762, G01L 9/00, F16C 11/06

(54) **Process for manufacturing integrated microstructures of single-crystal semiconductor material**

(71) Applicant: STMicroelectronics S.r.l., 20041 Agrate Brianza (Milano) (IT)
(72) Inventor: Murari, Bruno, 20052 Monza (IT); Ferrari, Paolo, 21013 Gallarate (IT); Vigna, Benedetto, 85100 Potenza (IT)
(74) Representative: Cerbaro, Elena

(57) **Abstract**

The process comprises forming a buried sacrificial layer (5) of porous silicon in the starting substrate (2) and then a single-crystal epitaxial layer (7) intended to accommodate both the sensitive element and the integrated circuit. After forming electronic components (12, 18) in the epitaxial layer, the epitaxial layer (7) is anisotropically etched over the buried sacrificial layer (5) to form trenches (27) through which the buried sacrificial layer is then etched and removed. The suspended mass (30) thus obtained has high mechanical properties, high thickness, the process is wholly compatible with standard microelectronics techniques and can be implemented at low cost.

## Description

The present invention relates to a process for manufacturing integrated microstructures of single-crystal semiconductor material.

As is known, the technique of "micromachining", based on manufacturing technologies typical of microelectronics, enables microsystems such as special microsensors, microactuators and micromechanisms to be produced by making use of the typical advantages and knowledge of microelectronics processes.

Historically, such microstructures have been manufactured by preferably using the "bulk micromachining" technique in which a wafer of silicon is machined on both faces, so as to exploit the excellent mechanical properties of single-crystal silicon. On the other hand, the existence of front-to-back machining processes and special wafer handling requirements renders bulk micromachining incompatible with the current techniques for manufacturing integrated circuits.

A further technique used for the construction of micro-systems utilizes etching solutions such as ethyldiamine pyrocatechol (EDP) or tetramethyl ammonium hydrate (TMAH). According to this technique the structure is formed and separated from the substrate by etching the solid silicon from the front of the wafer, with a technique which may be termed "front bulk micromachining".

In the mid-Eighties a technique known as "surface micro-machining", which is based on forming the sensitive element or the micromechanism from multi-crystal silicon, was proposed. The technique of surface micromachining makes it possible to form suspended structures thanks to the deposition and successive removal of sacrificial layers of different type, such as oxide or nitride of silicon, aluminium, photoresist, polyimide etc.

A survey of the techniques of surface micromachining (and of the techniques of bulk micromachining and associated characteristics) can be found, for example, in the article "Micromachining and ASIC technology", by Axel M. Stoffel, in Microelectronics Journal, 25 (1994), pages 145-156.

The suspended structures obtainable with the technique of surface micromachining do, however, have reduced bending strength and may therefore be subject to phenomena of collapse and stiction on the underlying layer, jeopardizing the desired mechanical, thermal and electrical insulation characteristics.

In the early Nineties a new technique for forming microstructures appeared, known as "silicon fusion bonding" and based on forming a cavity in a wafer of single-crystal silicon and bonding a further wafer of single-crystal silicon in which the sensor is formed.

A technique similar to the above provides the use of SOI (Silicon On Insulator) substrates, dedicated or otherwise, for the construction of microstructures.

Furthermore, an innovative process was developed, based on a combination of isotropic and anisotropic etching of the silicon to form suspended masses with a technique known as SCREAM (Single-Crystal Reactive Etching and Metallization) which does, however, require delicate fabrication steps such as the sputtering of the aluminium on the walls of the trenches, cf. for example the article by K.A. Show and N.C. MacDonald entitled "Integrating SCREAM Micromachined Devices with Integrated Circuits", Cornell University, IEEE, 0-7803-2985-6/96.

There are also highly specialized techniques, such as "wafer dissolving", which enable silicon microstructures to be formed by means of dedicated processes which are completely incompatible with the normal planar processes in microelectronics. In a sense, these "ad hoc" techniques consist of simply transposing to silicon that which is already done with other materials and only enable the sensitive part to be manufactured; consequently, all manufacturers who use this technique are obliged to form the control and processing circuit on a separate chip.

Finally, a further highly specialized technique is that known as LIGA, a German acronym for "Lithographie Galvanoformung Abformung" (Lithography Electroforming Moulding); this consists of three process steps including a lithograph, formed by means of synchrotron X-ray radiation, an electrodeposition of metallic films and a subsequent moulding, to form plastic moulds (cf. for example the text by S.M. Sze, "Semiconductor Sensors", John Wiley & Sons Inc., chapter 2, pages 75-78).

None of the techniques described above, however, permit the production of sensors at reduced costs, comparable with those of microelectronics techniques, with manufacturing steps that are known, readily controllable and not critical, which can be integrated in a single chip with the associated control electronics and with no risk of collapse of the suspended structures.

The object of the invention is therefore to provide a process for the manufacture of microstructures of semiconductor material which do not have the disadvantages of current techniques.

The present invention provides a process for manufacturing integrated microstructures of single-crystal semiconductor material, as defined in claim 1.

The idea on which the process is based consists in forming a buried sacrificial layer of porous semiconductor material (silicon) in the starting substrate and of a single-crystal epitaxial layer intended to accommodate both the sensitive element and the integrated circuit. A subsequent anisotropic etching of the epitaxial layer at the buried sacrificial layer or forming porous portions in the epitaxial layer extending as far as the buried sacrificial layer and chemically removing the porous region or regions permit the production of static, kinematic and dynamic microstructures.

For an understanding of the invention, a preferred embodiment will now be described, purely by way of non-exhaustive example, with reference to the accompanying drawings in which:
- Figs. 1-5 show transverse sections through a wafer of semiconductor material in successive manufacturing steps;
- Fig. 6a shows a transverse section similar to that of Figs. 1-5 in a subsequent manufacturing step;
- Fig. 6b shows a transverse section similar to that of Figs. 1-5 in a subsequent manufacturing step according to a variant of Fig. 6a;
- Fig. 7 shows a transverse section similar to the previous ones at the end of manufacture; and
- Fig. 8 shows a top view of the structure of Fig. 7.

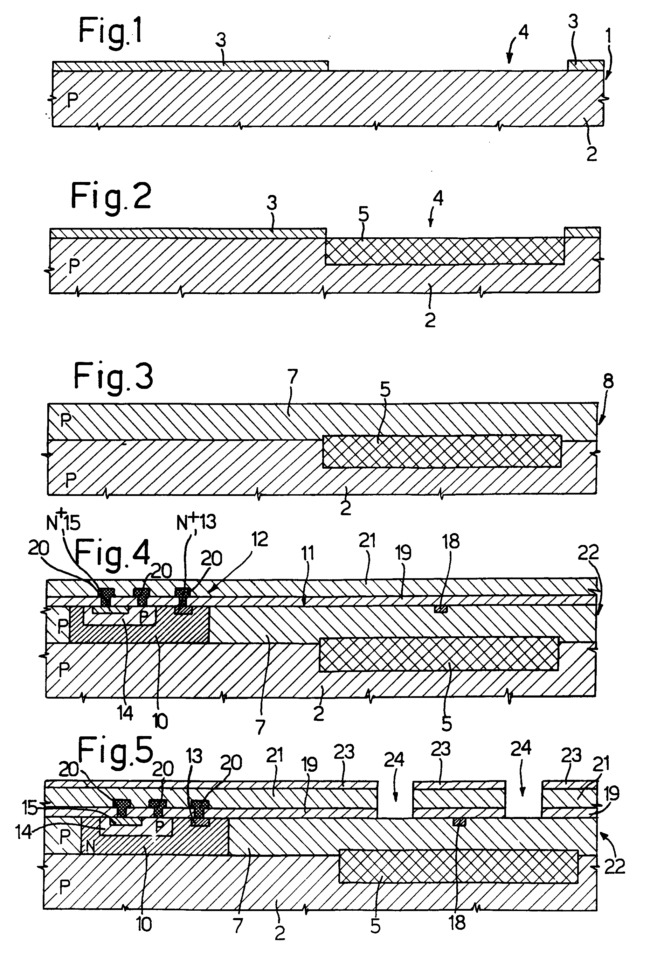

According to an embodiment of the process, with reference to Fig. 1, a mask 3 of silicon carbide having openings 4 at the zones in which a sacrificial layer of porous silicon is to be formed, is formed on top of a wafer 1 of P-type single-crystal silicon with a resistivity of approx. 10-18 Ωcm and defining the substrate 2 of the device.

Subsequently the wafer 1 is subjected to an anodizing process in an electrochemical cell containing an aqueous solution of hydrofluoric acid and ethanol for the formation of porous silicon. An example of an electrochemical cell which can be used for this purpose is described for example in the article by V. Lehmann, "Porous Silicon - A new Material for MEMS", IEEE 1996; this article provides a detailed description of the process to be followed if the chip is N-type; if the chip 1 is P-type, as in the present embodiment, the process is similar but the illumination of the wafer is not required. In particular, the current density required for the formation of porous silicon is between 10 and 100 mA/cm² inclusive depending on the strength of the solution and the concentration of the silicon; in the cell a positive voltage is applied to a platinum electrode and a negative voltage to the wafer 1. In these conditions the current flow between the two electrodes causes the formation of holes on the surface, giving rise to pores. Part of the substrate 2 underneath the opening 4 of the carbide mask 3 thus transforms from single-crystal silicon to porous silicon, forming a porous sacrificial region 5, as shown in Fig. 2.

The carbide mask 3 is then removed and a P-type epitaxial layer 7 is grown on the wafer 1, forming a wafer 8 (Fig. 3). The possibility of growing a layer of single-crystal silicon of optimum quality epitaxially on layers of porous silicon has recently been demonstrated for devices using SOI substrates, cf. for example C. Oules, A. Halimaoui, J.L. Regolini, A. Perio and G. Bomchil, "Silicon on Insulator Structures Obtained by Epitaxial Growth of Silicon over Porous Silicon", J. Electrochem. Soc., Vol. 139, No. 12, December 1992.

Conventional standard process steps for forming electronic components of integrated circuits are then carried out; in particular, in the example shown, N-type pockets 10, extending from the surface 11 of the epitaxial layer 7 as far as the substrate 2 and an NPN transistor 12 equipped with an N⁺-type collector contact region 12, a P-type base region 14 and an N⁺-type emitter region 15 are formed in the epitaxial layer 7. At this point, depending on the type of microstructure to be formed and the physical principle on which its operation is based, components or regions necessary for said microstructure may also be formed; in particular, process steps already present for forming the components of the integrated circuit or suitable steps may be used for the purpose.

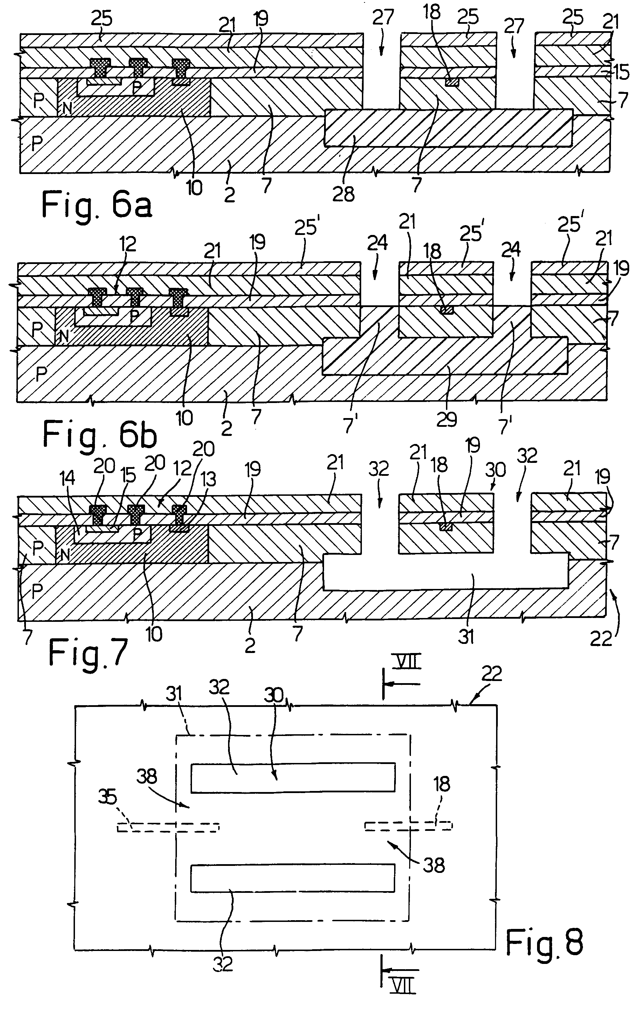

Reference will be made below, purely by way of example, to the production of a resonant-type acceleration sensor, which requires two integrated resistors extending at least in part at a suspended structure (shelf) as explained in greater detail below. In this case, therefore, at the same time as the step of implantation and diffusion of the emitter 15 and collector 13 contact regions, such integrated resistors may be formed; only one of them is visible in Fig. 4, denoted by 18. Alternatively, a heater element is formed in the case of a chemoresistive gas sensor, or piezoresistors in the case of a piezoresistive pressure sensor.

A dielectric layer 19 for forming contact openings of the electronic components of the integrated circuit and components associated with the suspended structure is then deposited, masked and etched on the surface 11 of the epitaxial layer 7; a metal layer for forming contacts 20 and metallic inter-connections is deposited and defined; and a dielectric passivation layer 21 is deposited, thus forming a wafer 22 shown in Fig. 4.

A resist mask 23 is then formed for the removal of the dielectric layers 19 and 21 in the zone of the contact pads (to permit the electrical contacting of the device, in a way not shown), and in the zone in which the suspended structure is to be formed, forming two openings 24 in the layers 19, 21, as shown in Fig. 5.

After the removal of the resist mask 23, steps preparatory to the removal of the buried sacrificial layer 5 are carried out. In particular these preparatory steps may be carried out according to two alternative possibilities. According to a first solution, using a suitable carbide mask 25 having openings slightly larger than the resist mask 23 (in a manner not shown), an RIE plasma etching of the epitaxial layer 7 is carried out, which leads to the formation of trenches 27 extending from the surface 11 of the epitaxial layer 7 as far as the porous sacrificial region 5, as shown in Fig. 6a; in this case etching automatically stops on the porous sacrificial region 5. Then, the porous sacrificial region 5 of silicon is oxidized through the trenches 27 (on this subject, see for example the article: "Silicon on Insulator Structures Obtained by Epitaxial Growth of Silicon over Porous Silicon" op. cit.) and forms a first oxidized sacrificial region 28, as shown in Fig. 6a.

According to the variant of Fig. 6b, the preparatory steps comprise forming a carbide mask 25' wholly similar to that of Fig. 6a and oxidating portions of the epitaxial layer 7 underneath the openings 24 and the entire porous sacrificial region 5, forming a second oxidized sacrificial region 29, as shown in Fig. 6b.

Finally, the oxidized sacrificial region 28 or 29 is removed in hydrofluoric acid, permitting, after the removal of the mask 25 or 25', a suspended mass 30 to be obtained above an air gap 31 and separated from the rest of the wafer 22 by trenches 32, as shown in Fig. 7.

In this way it is possible to obtain structures which are thermally insulated from the substrate (static structures), structures which detect an external signal through the effect of their movement (kinematic structures) and micromotors/microactuators (dynamic structures).

In particular, Fig. 8 shows a top view of the final structure in the case of a resonant acceleration sensor with thermal excitation and piezoresistive detection, as described for example in W. Riethmüller and W. Benecke, "Thermally Excited Silicon Microactuators", IEEE Trans. on Electron Devices, Vol. 35, No. 6, June 1988. The shelf formed by the suspended mass 30, delimited at the sides by the trenches 32, is visible in this Fig.; the outer perimeter of the air gap 31 has also been shown in dot-and-dash lines. Two resistors 18 and 35, shown by broken lines, extend longitudinally to the shelf 30, in the anchorage zones thereof (denoted by 38), partially superimposed on the air gap 31. By means of metal lines which are not shown, these resistors are connected to the components of the circuitry which provide to process the signal supplied by the resistors.

The resonant acceleration sensor of Fig. 8 operates in the following manner. When one of the two resistors (constituting the acceleration resistor, element 18 for example) is flowed by a current which varies over time, because of the variable thermal gradient which exists in the thickness of the shelf 30 of single-crystal silicon, transverse stationary oscillations are established which have the anchorage zones 38 of the shelf as nodes. The other resistor (forming the detection resistor, in this case element 35) enables the frequency of the oscillations of the suspended part to be measured, by measuring the variations of the associated electrical variables.

When the sensor is subjected to an acceleration perpendicular to its largest surface (and hence to the surface 11 of the epitaxial layer) the shelf 30 deflects in the same direction as the inertial force. Elastic reaction forces are thus generated which cause a state of stress in the structure and in its turn this stress induces a displacement of the frequencies of the oscillation proper of the shelf 30. This displacement may be measured through the detection resistor 35 and enables the value of the acceleration to be obtained.

The advantages of the described method and the sensor are as follows. Firstly, it enables exploitation of the advantages offered by bulk micromachining and surface micromachining without sharing their disadvantages. In fact, by using this process, it is possible to form a suspended mass whose horizontal dimensions are comparable with those obtainable by surface micromachining and hence smaller than those obtainable with bulk micromachining. On the other hand the process enables the suspended mass to be made of single-crystal silicon, which has optimum mechanical properties, in a manner similar to bulk micromachining. Consequently the micromechanical structures which may be obtained with this process are extremely robust and do not suffer potential thermo-mechanical stresses.

The structure which may be obtained is essentially planar and requires additional process steps, with respect to those required to form the components of the integrated circuit, of a more limited number than in the case of surface micromachining, due to the definition of the porous silicon and the etching of the trenches.

The suspended mass formed is thicker than structures having films deposited according to the technique of surface micromachining, permitting the achievement of greater sensitivity of the sensor formed on or in the suspended structure, with resultant fewer problems in signal processing.

Thanks to the greater bending strength in the direction perpendicular to the wafer, the suspended mass which may be obtained with the process is extremely unlikely to stick onto the substrate as occurs during removal of the sacrificial layer, typical of structures formed with surface micromachining techniques. Furthermore, the great thickness of the sacrificial layer of porous silicon reduces the extent of the capillarity forces responsible for the stiction of the suspended mass to the substrate.

The manufacturing process described has extremely reduced costs compared with those which provide the use of SOI substrates or Silicon Fusion Bonded substrates.

Finally, delicate manufacturing steps such as the sputtering of the aluminium on the walls of the trenches, which is necessary in the SCREAM technique for example, are not required.

Finally it will be clear that numerous modifications and variants may be introduced to the process described and illustrated herein, all coming within the scope of the inventive concept as defined in the accompanying claims. For example, the conductivity of the layers may be different from that shown; the integrated electronic components may be either bipolar or MOS; the structure obtained may be used for all types of sensors, microactuators and micromechanisms using masses of semiconductor material which are suspended or isolated from the rest of the wafer.

## Claims

1. A process for manufacturing integrated microstructures comprising a suspended mass (30) of single-crystal material, characterized by the steps of:
- forming a sacrificial region (28; 29) of porous material inside a body (22) of single-crystal semiconductor material;
- removing said sacrificial region through openings (27; 7') in said body.

2. A process according to Claim 1, characterized in that said step of forming a sacrificial region (28; 29) comprises the steps of:
- selectively treating a substrate portion (2) of single-crystal semiconductor material to form a porous semiconductor material portion (5); and
- subsequently growing an epitaxial layer (7) of single-crystal silicon on said substrate (2).

3. A process according to Claim 2, characterized in that said step of selectively treating comprises the steps of:
- masking said substrate (2) forming a mask (3) having an opening (4) at said substrate portion;
- anodizing said substrate portion in an electrochemical cell comprising an anodizing solution.

4. A process according to Claim 2 or 3, characterized in that said step of removing said sacrificial region (28; 29) comprises the steps of:
- oxidizing said porous semiconductor material portion (5) to obtain an oxidized porous material portion (28; 29); and
- chemically etching said oxidized porous material portion.

5. A process according to Claim 4, characterized in that said step of oxidizing comprises the steps of: removing selective portions of said epitaxial layer (7) on top of said porous semiconductor material portion (5) to form trenches (27) and oxidizing said porous semiconductor material portion through said trenches.

6. A process according to Claim 4, characterized in that said step of oxidizing comprises the steps of: masking said epitaxial layer (7) by means of a mask (25') having openings over said porous semiconductor material portion (5); and oxidizing portions of said epitaxial layer disposed underneath said openings to form an oxidized region (29) comprising epitaxial layer oxidized portions (7') and said oxidized porous material portion.

7. A process according to Claim 6, characterized in that said step of etching comprises the step of removing said epitaxial layer oxidized portions (7').

8. A process according to one of Claims 2-7, characterized in that process steps for forming electronic components (12, 18) in said epitaxial layer and inter-connections (20) are carried out after said step of growing an epitaxial layer (7) and before said step of removing said sacrificial region (28; 29).

9. A process according to Claim 8, characterized in that said process steps comprise the step of implanting resistive elements (18) in said epitaxial layer (7), said resistive elements extending at least partially over said sacrificial region (28; 29) for forming an acceleration microsensor.
